# EUROPÄISCHE PATENTSCHRIFT

(11) **EP 0 996 979 B1**
(45) Veröffentlichungstag und Bekanntmachung des Hinweises auf die Patenterteilung: **13.10.2004**
(21) Anmeldenummer: 98941269.7
(22) Anmeldetag: 03.07.1998
(51) Int. Cl.: H01L 23/31

(54) **GEHÄUSE FÜR ZUMINDEST EINEN HALBLEITERKÖRPER**
HOUSING FOR AT LEAST ONE SEMICONDUCTOR BODY
BOITIER POUR AU MOINS UN CORPS SEMI-CONDUCTEUR

(30) Priorität: 07.07.1997 DE 19728992
(43) Veröffentlichungstag der Anmeldung: 03.05.2000
(73) Patentinhaber: Infineon Technologies AG, 81669 München (DE)
(72) Erfinder: LEE, Charles-Wee-Ming, Singapore #03-152 S(090110) (SG)
(74) Vertreter: Schweiger, Martin
(86) Internationale Anmeldenummer: PCT/DE1998/001851
(87) Internationale Veröffentlichungsnummer: WO 1999/003153

(56) Entgegenhaltungen:
- DE-A- 19 500 655
- US-A- 5 289 346
- US-A- 5 496 775
- PATENT ABSTRACTS OF JAPAN vol. 097, no. 004, 30. April 1997 & JP 08 335653 A (NITTO DENKO CORP), 17. Dezember 1996 & US 5 814 894 A (KAZUMASA IGARASHI AND AL.) 29. September 1998
- PATENT ABSTRACTS OF JAPAN vol. 014, no. 359 (E-0959), 3. August 1990 & JP 02 125633 A (NEC CORP), 14. Mai 1990
- PATENT ABSTRACTS OF JAPAN vol. 096, no. 005, 31. Mai 1996 & JP 08 017864 A (NEW JAPAN RADIO CO LTD), 19. Januar 1996
- PATENT ABSTRACTS OF JAPAN vol. 005, no. 099 (E-063), 26. Juni 1981 & JP 56 043748 A (SEIKO INSTR & ELECTRONICS LTD), 22. April 1981
- BABA S ET AL: "Molded chip scale package for high pin count" 1996 PROCEEDINGS. 46TH ELECTRONIC COMPONENTS AND TECHNOLOGY CONFERENCE (CAT. NO.96CH35931), 1996 PROCEEDINGS 46TH ELECTRONIC COMPONENTS AND TECHNOLOGY CONFERENCE, ORLANDO, FL, USA, 28-31 MAY 1996, Seiten 1251-1257, XP002088432 ISBN 0-7803-3286-5, 1996, New York, NY, USA, IEEE, USA

## Beschreibung

Die vorliegende Erfindung betrifft ein Gehäuse für zumindest einen Halbleiterkörper.

Eine gattungsgemäße, nachfolgend kurz als "Gehäusebauteil" bezeichnete Einheit kann beispielsweise ein Speicherbaustein sein, der beispielsweise zur Montage auf einer Leiterplattenanordnung vorgesehen ist.

Bei komplexen Halbleiterkörpern, insbesondere bei Speicherbausteinen, nimmt die Anzahl der externen Kontakte, den sogenannten I/O-Ports, immer mehr zu. Es sind heute Chips mit mehr als tausend I/O-Ports realisiert, möglich sollen einige tausend I/O-Ports werden. Um dieser Anforderung gerecht zu werden, werden bei derartigen Gehäusebauteilen aus Platzgründen die I/O-Ports üblicherweise nicht mehr seitlich am Chiprand herausgeführt, sondern die Kontakte werden von einer Oberfläche de Halbleiterkörpers herausgeführt. Da die Anschlußpads nicht am Chiprand plaziert sein müssen, kann das Signal vorteilhafterweise direkt an der Stelle aus dem Chip herausgeführt, wo es erzeugt wird. Durch diese extrem kurzen Wege erweisen sich derartige Bauelemente - insbesondere für hochfrequente Anwendungen - als vorteilhaft. Außerdem bietet ein derartiges Bauelement die geringste Einbaufläche wegen der kleineren Anschlußpads.

Ein derartiger Baustein kann beispielsweise ein sogenannter Flip-Chip-Baustein sein. Der Flip-Chip-Baustein ist nicht gehäust und gehört zur Kategorie der Nacktchips (englisch: bare die). Die hier verwendete Verbindungstechnologie wird C4 genannt und steht für Control-Collapse-Chip-Connection. Die C4-Technologie wird seit über zwanzig Jahren in einer Vielzahl von Produkten eingesetzt.

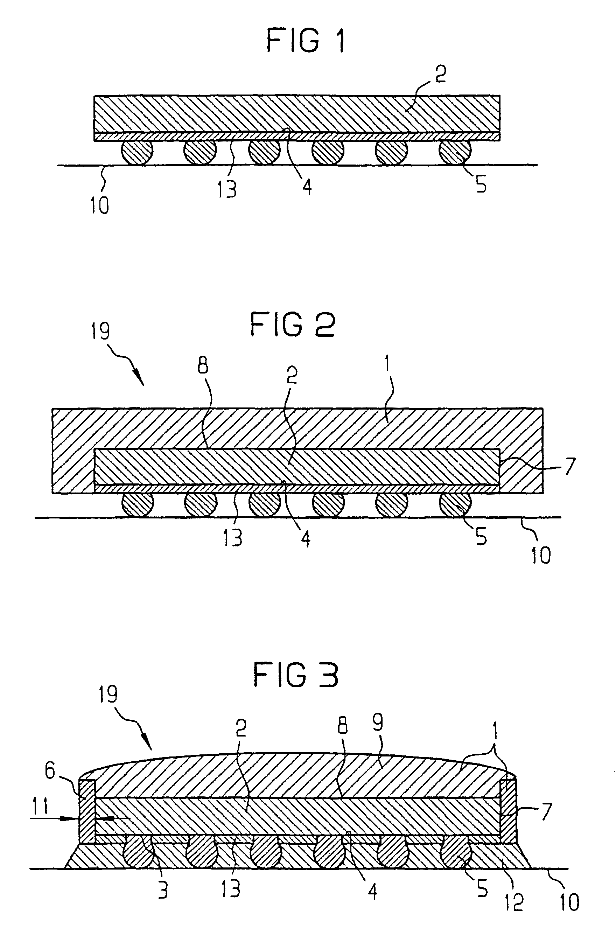

Figur 1 der Zeichnung zeigt einen gebondeten Flip-Chip-Baustein. An der Vorderseite 4 eines Halbleiterkörpers 2 befinden sich gebondete Anschlußelemente 5. Über diese Anschlußelemente 5 läßt sich der Halbleiterkörper 2 mit einer Leiterplatte 10 verbinden. Im vorliegenden Beispiel sind die Anschlußelemente kugelförmig ausgebildet. Die kugelförmigen Anschlußelemente können beispielsweise in Ball-Grid-Array (BGA-)Technologie an den Silicium-Chip gebondet sein. An den nicht kontaktierten Bereichen der Chipvorderseite 4 ist eine Passivierungsschicht 13 aufgebracht. Da die in Flip-Chip-Technologie hergestellten Halbleiterkörper kein Gehäuse aufweisen, ist hier das Chip/Gehäuse-Verhältnis optimal. Derartige Bauteile lassen sich jedoch prozeßtechnisch, insbesondere beim Transport, äußerst schwierig handhaben. Dies hat zwangsläufig eine erhöhte Ausschußrate zur Folge. Des weiteren sind derartige Bauelemente äußeren Einflüssen, wie mechanischem Streß, Feuchtigkeit, Temperatureinflüssen, ungeschützt ausgesetzt. Ein nicht gekapselter Baustein läßt sich nach der Herstellung außerdem nicht mehr lasermarkieren.

Ein weiteres Gehäuse für einen Halbleiterkörper der eingangs genannten Art ist in Figur 2 gezeigt. Gleiche beziehnungsweise funktionsgleiche Bauelemente sind mit gleichen Bezugszeichen versehen. Figur 2 zeigt einen Halbleiterkörper 2, an dessen Vorderseite 4 Anschlußelemente 5 gebondet sind. Die Randfläche 7 und die Chiprückseite 8 sind jeweils von einem Gehäuse 1 ummantelt. Die nicht kontaktierten Bereiche der Chipvorderseite 4 können, wie im vorliegenden Beispiel gezeigt, durch eine Passivierungsschicht 13 bedeckt sein. Über die Anschlußelemente 5, die im vorliegenden Beispiel kugelförmig ausgebildet sind, ist der Halbleiterkörper 2 mit einer Leiterplatte 10 verbindbar. Das Gehäuse 1 wird üblicherweise durch Anpressen einer Kunststoffmasse an den Halbleiterchip hergestellt.

Eine derartiges Gehäusebauteil 19 ist als Chip-Scale-Package (CSP), oft auch als Chip-Size-Package, bekannt. Diese Technologie scheint dafür geeignet zu sein, den Technologiesprung zur Flip-Chip-Montage zu überbrücken, da hier einige Nachteile der Flip-Chip-Technik umgangen werden. Wie schon der Name bezeichnet, ist dieses Gehäuse um einen bestimmten Faktor größer als der Chip. Gemäß dem Normierungsvorschlag darf ein Gehäuse nur dann als CSP-Gehäuse bezeichnet werden, wenn es maximal um den Faktor 0,2 größer ist als der Chip selbst. Dieser Wert spiegelt sich im Verhältnis Gehäusefläche zu Chipfläche wieder.

CSP-Gehäuse weisen gegenüber Flip-Chip-Bausteinen die Vorteile auf, daß sie gegenüber Schäden beim Transport, Herstellung oder gegenüber sonstigen äußeren Einflüssen geschützt sind. Außerdem lassen sich CSP-Gehäuse lasermarkieren. Allerdings weisen CSP-Gehäusebauteile gegenüber Flip-Chip-Bauteilen den Nachteil eines Chip/Gehäuse-Verhältnis von < 1 auf. Außerdem ist die Kapselung eines Kunststoffgehäuses oft sehr kompliziert und sehr teuer. Derartige Bauelemente weisen auch eine höhere Ausschußrate auf, da es beispielsweise durch einen asymmetrischen Fluß der Kunststoffmasse bei der Herstellung des Gehäuses zu Defekten wie Hohlräumen oder feinsten Löchern im Kunststoff kommen kann.

Aus der JP A-02 125633 ist ein Halbleiterbauelement mit einem zweiteiligen Gehäuse bekannt, wobei der erste Teil des Gehäuses einen Stützrahmen aufweist, der die Randflächen des Halbleiterkörpers vollständig umfaßt und sich am Rand des Halbleiterkörpers von dessen Seitenoberfläche abhebt. Der zweite Teil des Gehäuses weist einen flach ausgebildeten Deckel auf, der flächendeckend die zweite Oberfläche und teilweise eine obere Kante des Stützrahmens überdeckt. Ein ähnliches Halbleiterbauelement ist aus JP-A-56 043748 bekannt, bei dem ein Halbleiterchip an seinen flachen Seiten von einem Stützrahmen vollständig umgeben ist. Eine passive Rückseite des Halbleiterchips bleibt dagegen frei.

Ausgehend von diesem Stand der Technik ist es daher die Aufgabe der vorliegenden Erfindung ein Gehäuse für einen Halbleiterkörper anzugeben, das ein im Vergleich zur CSP-Technologie deutlich höheres Chip/Gehäuse-Verhältnis aufweist und das auf einfache Weise und kostengünstig herstellbar ist sowie die obigen Nachteile nicht aufweist.

Erfindungsgemäß wird diese Aufgabe durch ein Gehäuse für zumindest einen Halbleiterkörper gelöst, bei dem
(a) der Halbleiterkörper eine erste und zweite Oberfläche, eine den Halbleiterkörper umfassende Randfläche und eine Vielzahl von Kontaktstellen an der ersten Oberfläche aufweist,
(b) mit einer Vielzahl von Anschlußelementen, die mindestens teilweise mit den Kontaktstellen des Halbleiterkörpers kontaktiert sind und über die der Halbleiterkörper mit einer Leiterplatte elektrisch kontaktierbar ist,
(c) wobei das Gehäuse zweiteilig ausgeführt ist,
   - wobei der erste Teil des Gehäuses einen wenige dünnen Stützrahmen aufweist, der die Randfläche des Halbleiterkörpers vollständig umfaßt und sich am Rand des Halbleiterkörpers von der zweiten Oberfläche des Halbleiterkörpers abhebt, und
   - der zweite Teil des Gehäuses einen möglichst flach ausgebildeteten Deckel aufweist, der flächendeckend die zweite Oberfläche und zumindest teilweise die obere Kante des Stützrahmens überdeckt.

Derartige erfindungsgemäße Gehäusebauteile werden nachfolgend als PBCSP-Gehäuse (Polymer Bumper Chip Scale Package) bezeichnet.

Mit der vorliegenden Erfindung lassen sich sämtliche Vorteile der Flip-Chip-Technologie und der CSP-Technologie auf einfache Weise vereinen, ohne die damit einhergehenden Nachteile in Kauf zu nehmen.

Der wesentliche Vorteil der vorliegenden Erfindung liegt darin, daß das erfindungsgemäße zweiteilig aufgebaute PBCSP-Gehäusebauteil aufgrund des sehr dünnen Stützrahmens ein optimiertes Chip/Gehäuse-Verhältnis aufweist. Dabei läßt sich das Gehäuse auf einfache Weise und sehr kostengünstig herstellen.

Ferner ist das gefertigte Gehäusebauteil gegenüber äußeren Einflüssen sowie gegenüber Schäden bei Transport und Herstellung geschützt. Das fertige Gehäusebauteil läßt sich vorteilhafterweise lasermarkieren.

Das Material des Stützrahmens weist üblicherweise eine sehr hohe Viskosität auf. Typischerweise ist die Stützmasse bei Raumtemperatur äußerst konsistent. Hingegen weist die Masse des Deckels eine sehr viel niedrigere Viskosität als die Stützmasse auf. Üblicherweise wird die Stützmasse zuerst aufgebracht und dient beim nächsten Prozeßschritt als Fließstop für die Masse des Deckels. Auf diese Weise wird verhindert, daß die bei der Herstellung aufgebrachte und noch flüssige Deckelmasse über den Rand der Halbleiterkörper fließt.

Als Stützmasse wird üblicherweise ein Polymer verwendet. Das Polymer weist bei Raumtemperatur eine sehr hohe Viskosität auf und ist somit unter Normalbedingungen äußerst konsistent. Dies ist insbesondere dann vorteilhaft, wenn das Gehäuse zwischen den Prozeßschritten maschinell transportiert oder gehandhabt wird. Als Stützmasse können auch andere gängige Kunststoffe oder ähnliche Materialien, die bei Raumtemperatur eine sehr hohe Viskosität aufweisen, verwendet werden.

Als Deckelmasse wird typischerweise ein sogenanntes Glob-Top verwendet. Das Glob-Top kann beispielsweise ein Epoxidharz oder ein gängiges anderes Harz sein. Es ist auch denkbar, als Glob-Top eine gelartige Substanz oder etwas ähnliches zu verwenden.

Typischerweise sind die nicht mit Kontaktstellen versehenen Bereiche an der Chipvorderseite durch eine Passivierungsschicht geschützt. Auf diese Weise wird die Chipvorderseite vor Umwelteinflüssen, wie Feuchtigkeit, mechanischen Streß, Korrosion, etc. geschützt.

Besonders vorteilhaft ist es, wenn die Bereiche zwischen den Anschlußelementen und der Leiterplatte durch einen Füllstoff aufgefüllt sind. Auf diese Weise werden insbesondere die Kontaktanschlüsse geschützt. Brüche der Anschlußelemente, die zu einer Fehlfunktion des Halbleiterbauelements führen, können durch diese Maßnahme vermieden werden.

Ein Herstellungsverfahren der erfindungsgemäßen Gehäusebauteile ist im Anspruch 4 angegeben.

Bei der Herstellung der Gehäusebauteile ist es zwingend notwendig, daß die Oberflächen der Halterung, die mit dem Gehäusebauteil in Berührung kommen können, aus nichthaftendem Material bestehen. Ansonsten würden die gerade gefertigten Gehäuseteile beim Herauslösen aus der Halterung möglicherweise beschädigt werden.

Als nichthaftendes Material sollte ein Material verwendet werden, das bei hohen Temperaturen nicht mit dem Material des Gehäusebauteils, reagiert. Typischerweise wird als nichthaftendes Material Teflon verwendet. Es ist jedoch auch denkbar, jedes andere Material mit ähnlichen Materialeigenschaften zu verwenden.

Besonders vorteilhaft ist es, wenn die Halterung für die Gehäusebauteile aus einer m x n -Matrix besteht. Auf diese Weise lassen sich mehrere Gehäusebauteile gleichzeitig prozessieren, wodurch sich die Herstellungskosten der Gehäusebauteile drastisch senken lassen.

Nachfolgend wird die Funktion der erfindungsgemäßen Anordnung anhand der in den Figuren der Zeichnung angegebenen Ausführungsbeispiele näher erläutert. Es zeigt:
- Figur 1: einen Halbleiterkörper mit Flip-Chip-Technologie nach dem Stand der Technik;
- Figur 2: ein Beispiel für ein CSP-Gehäuse nach dem Stand der Technik;
- Figur 3: ein erfindungsgemäßes sogenanntes PBCSP-Gehäuse; und
- Figur 4: ein bevorzugtes Herstellungsverfahren für ein erfindungsgemäßes PBCSP-Gehäuse anhand von vier Prozeßschritten.

Figur 3 zeigt ein erfindungsgemäßes PBCSP-Gehäuse. Gleiche bzw. funktionsgleiche Elemente werden entsprechend der Figuren 1 und 2 mit gleichen Bezugszeichen versehen.

Das Gehäusebauteil in Figur 3 zeigt ein Gehäuse 1, das einen Halbleiterkörper 2 umfaßt. Der Halbleiterkörper 2 kann beispielsweise ein Siliziumchip sein. An der ersten Oberfläche 4 des Halbleiterkörpers 2 befinden sich Kontaktstellen 3. Über diese Kontaktstellen 3 läßt sich der Halbleiterkörper 2 elektrisch kontaktieren. Im vorliegenden Beispiel werden die Kontaktstellen 3 des Halbleiterkörpers 2 durch zum Teil kugelförmige Anschlußelemente 5 kontaktiert. Die nicht kontaktierten Bereiche der ersten Oberfläche 4 sind im vorliegenden Beispiel durch eine Passivierungsschicht zum Schutz der Oberfläche bedeckt. Über die Anschlußelemente 5 läßt sich der Halbleiterkörper 2 mit entsprechenden Kontakten einer Leiterplatte 10 elektrisch verbinden. Im vorliegenden Beispiel sind die Bereiche zwischen dem Gehäusebauteil 19 und der kontaktierten Leiterplatte durch einen Füllstoff 12 aufgefüllt.

Das Gehäuse 1 umfaßt den Halbleiterkörper 2 in der Weise, daß die Randfläche 7 des Halbleiterkörpers 2 sowie die zweite Oberfläche 8 vom Gehäuse 1 überdeckt werden. Erfindungsgemäß besteht das Gehäuse 1 aus einem Stützrahmen 6 und einem Dekkel 9.

Dabei umhüllt der Stützrahmen 6 ganzflächig die Randfläche 7 des Siliziumchips 2. Der Stützrahmen 6 weist eine Breite 11 auf. Erfindungswesentlich ist jedoch, daß der Stützrahmen 6 am Rand des Siliziumchips 2 sich von der zweiten Oberfläche 8 abhebt. Auf der Seite der ersten Oberfläche 4 schließt der Stützrahmen 6 typischerweise jedoch nicht notwendigerweise mit der ersten Oberfläche 4 ab.

An der zweiten Oberfläche 8 des Siliziumchips 2 überdeckt der Deckel 9 ganzflächig den Siliciumchip 2. Der Deckel 9 kann dabei teilweise auch den Stützrahmen 6 überdecken.

Der Querschnitt des Stützrahmens 6 hat idealerweise die Form eines Rechtecks mit der Breite 11. Dies ist aber nicht zwingend notwendig. Tatsächlich ist die Form des Querschnitts des Stützrahmens 6 abhängig von Materialeigenschaften bzw. von der angewendeten Technlogie.

Erfindungswesentlich ist, daß der Stützrahmen 6 sehr dünn ist, um so ein möglichst optimales Chip-Gehäuse-Verhältnis zu gewährleisten. Je nach angewendeter Technologie und Material des Stützrahmens 6 ist es so möglich, daß der Stützrahmen 6 eine Breite 11 von wenigen µm aufweist. Damit lassen sich Gehäusebauteile 19 mit einem Chip-Gehäuse-Verhältnis von etwa eins realisieren.

Des weiteren ist es sehr wichtig, daß der Deckel 9 möglichst flach ausgebildet ist, um den Anforderungen einer flachen Gehäusebaureihe zu entsprechen.

Erfindungsgemäß können diesen Anforderungen in der Weise entsprochen werden, daß die Masse des Stützrahmens 6 eine sehr hohe Viskosität aufweist, während die Masse des Deckels eine sehr viel niedrigere Viskosität aufweist. Bei der Herstellung wird zunächst der Stützrahmen 6 hergestellt. Anschließend wird auf die Chiprückseite 8 der Deckel 9 aufgebracht. Der Stützrahmen 6 bildet dabei einen Fließstop für die niederviskose Masse des Deckels 9.

Typischerweise wird als Material des Stützrahmens 6 ein Polymer oder ein gängiges Kunststoffmaterial verwendet. Die Masse des Stützrahmens 6 wird bei hoher Temperatur aufgebracht. Bei Raumtemperatur hat die Masse 1 des Stützrahmens 6 vorteilhafterweise ihre höchste Viskosität und ist äußerst verformungskonsistent.

Das Material des Deckels 9 ist typischerweise ein gängiges, sogenanntes Glob-Top-Material oder ein gelartiges Material mit ähnlichen Materialeigenschaften. Die Deckelmasse wird ebenfalls bei hoher Temperatur aufgebracht, typischerweise durch Aufgießen, Aufspritzen, Abtropfen, oder ähnlichem. Auf diese Weise wird gewährleistet, daß die Deckelmasse gleichförmig und flächendeckend sich über die Oberfläche des Siliziumchips verteilt. Zur gleichmäßigen Verteilung kann der Siliziumchip 2 auch auf einem Rotation-Chuck bei hoher Drehzahl gedreht werden. Nach dem Erkalten erhöht sich die Visikosität, wodurch der Deckel verformungskonsistenter wird. Jedoch erreicht der Deckel 9 nicht die Härte des Stützrahmens 6.

Damit der Stützrahmen 6 und der Deckel 9 bei Temperaturschwankungen ihre Form beibehalten, erfolgt anschließend ein Aushärtschritt. Dabei wird durch ein Temperaturschritt der Stützrahmen 6 und der Deckel 9 ausgehärtet. Beim Aushärten wird die Viskosität der noch zähflüssigen Abdeckmasse und Stützmasse sehr stark erhöht. Dieser Temperaturschritt erfolgt typischerweise für eine Stunde bei 100°C Ofentemperatur. Es ist jedoch auch denkbar die Aushärtung durch UV-Licht durchzuführen.

Die Verwendung eines Füllstoffes 12 zwischen Gehäusebauteil und Leiterplatte 10 ist nicht zwingend notwendig. Aus mechanischen und elektrischen Gründen ist die Verwendung eines Füllstoffes 12 jedoch vorzuziehen, da dadurch beispielsweise Kontaktbrüche durch mechanischen Streß vermieden werden. Des weiteren werden die Anschlußelemente 5 und Anschlußpads vor Korrosion durch Feuchtigkeit geschützt.

Typischerweise sind die Anschlußelemente des Gehäuses 1 derart angeordnet, daß sie mit entsprechenden Anschlußelementen 5 an der Leiterplatte 10 kontaktierbar sind. Besonders vorteilhaft ist es bei Verwendung eines BGA-Gehäuses, wenn die Anschlußelemente kugelförmige Bereiche aufweisen. Durch die kugelförmigen Anschlußelemente 5 ist es auf einfache Weise möglich, Lotverbindungen zwischen dem Halbleiterkörper 2 und der Leiterplatte 10 herzustellen.

Der Deckel 9 dient vor allem dem mechanischen Schutz der Oberfläche bzw. zum Schutz vor Feuchtigkeit und vor äußeren Einflüssen. Der Deckel 9 ist jedoch nicht dafür geeignet, daß das Gehäusebauteil 19 an der Oberfläche des Deckels 9 beispielsweise für den maschinellen Transport gehandhabt wird. Hierfür ist der Stützrahmen 6 vorgesehen, dessen Konsistenz sehr viel härter ist als die des Deckels 9. Der Stützrahmen 6 ist dafür geeignet, das Gehäusebauteil 19 beispielsweise maschinell zu transportieren, ohne daß das Gehäusebauteil 19 durch den Transport oder durch sonstige Handhabung Schaden nimmt.

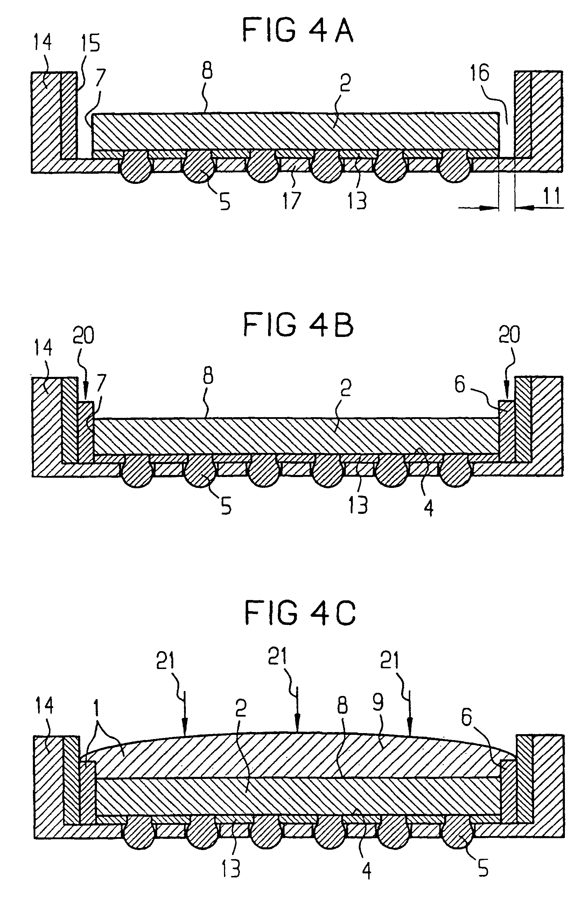

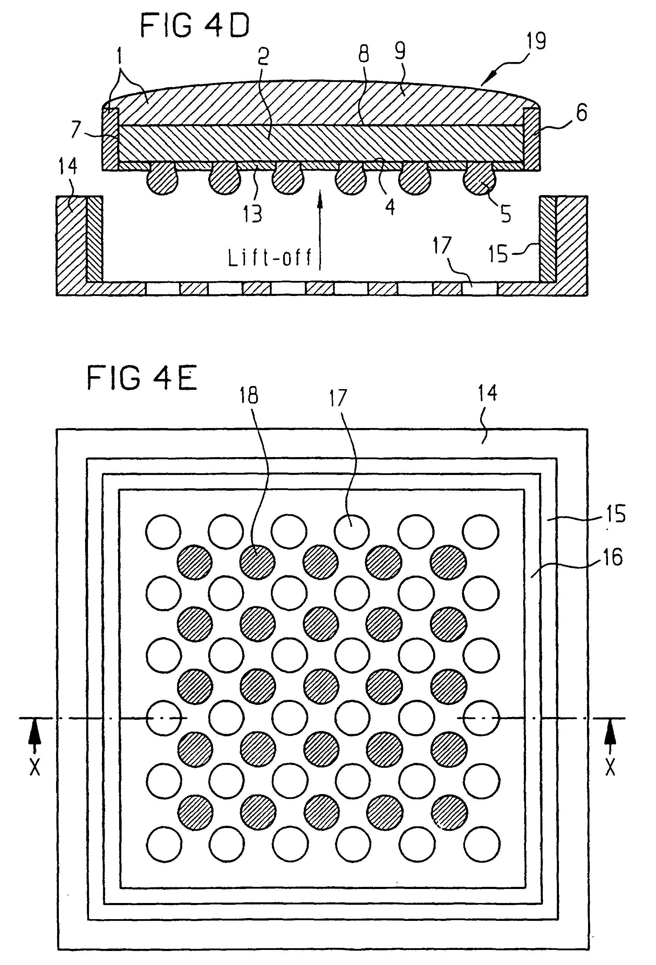

Nachfolgend wird ein vorteilhaftes Herstellungsverfahren für die erfindungsgemäßen PBCSP-Gehäusebauteile anhand von Figur 4 der Zeichnung näher erläutert. Gleiche bzw. funktionsgleiche Elemente sind entsprechend Figur 3 mit gleichen Bezugszeichen versehen.

Figur 4 (A) zeigt den Querschnitt einer Halterung 14 für ein mit Anschlußelementen 5 versehenen Siliziumchip 2. Am Boden der Halterung 14 sind Kontaktelementelöcher 17 zur Aufnahme der Anschlußelemente 5 des Siliziumchips 2 vorgesehen. Der Durchmesser der Löcher 16 für die Anschlußelemente 6 ist dabei typischerweise marginal größer als der Durchmesser der Anschlußelemente 5.

Die Innenwände der Halterung 14 sind ganzflächig mit einem nicht haftenden Material 15 bedeckt. Als nicht haftendes Material wird typischerweise Teflon verwendet. Der Siliziumchip 2 ist in der Halterung 14 in der Weise angeordnet, daß die Randfläche 7 des Siliziumchips 2 von der seitlichen Innenwand 15 der Halterung 14 beabstandet ist. Der Abstand zwischen dem Rand 7 des Siliziumchips 2 und der Innenwand der Halterung 14 definiert einen Spalt 16 mit der Breite 11. Der Spalt 16 weist typischerweise aber nicht notwendigerweise eine konstante Breite 11 auf.

Nach dem Positionieren des Siliziumchips 2 auf der Halterung 14 wird entsprechend Figur 4 (B) in den Spalt 16 die Stützmasse 20 maschinell eingebracht. Dies kann durch Einspritzen bzw. Aufgießen bei geeigneter Temperatur erfolgen. Da die Stützmasse 20 typischerweise eine sehr hohe Viskosität bei Raumtemperatur aufweist, ist für das Aufbringen der Stützmasse 20 eine sehr hohe Temperatur, üblicherweise einige 100°C, erforderlich. Der Spalt 16 wird dabei bis über die Oberfläche 8 des Siliziumchips 2 hinaus aufgefüllt.

Nachdem der Spalt 16 mit der Stützmasse 20 aufgefüllt wurde, erfolgt üblicherweise ein Temperaturschritt zum Aushärten. Dieser Aushärtschritt ist notwendig, damit der Stützrahmen 6 des Gehäusebauteils 19 formkonsistent bleibt. Das Aushärten des Stützrahmens 6 erfolgt typischerweise bei hoher Temperatur. Jedoch ist darauf zu achten, daß die Aushärttemperatur unterhalb der Schmelztemperatur der Anschlußelemente 5 bzw. der Kontaktstellen 3 und Metallisierungen liegt.

Das Aushärten der Stützmasse 20 kann jedoch auch durch sogenanntes Schnellaushärten in Luft bei Raumtemperatur bzw. bei leicht erhöhter Temperatur erfolgen. Je nach Material des Stützrahmens ist auch ein Aushärten durch UV-Licht denkbar.

In jedem Fall ist es vorteilhaft, wenn das Aushärten in Vacuum erfolgt, um so eingeschlossene Luftblasen entfernen zu können.

Entsprechend Figur 4 (C) wird anschließend auf die Oberfläche 8 des Siliziumchips 2 gleichmäßig die Abdeckmasse 21 für den Deckel 9 aufgebracht. Die Abdeckmasse 21 hat dabei eine sehr viel niedrigere Viskosität als die Masse 20 des Stützrahmens 6. Aus diesem Grund läßt sich die Abdeckmasse 21 vorteilhafterweise bei sehr viel niedrigerer Temperatur aufbringen als die Masse 20 des Stützrahmens 6. Die Abdeckmasse 21 kann dabei je nach Prozeßmaschine entweder aufgeschleudert, aufgespritzt, aufgegossen, etc. werden. Das Aushärten des Deckels 9 erfolgt typischerweise ähnlich wie das Aushärten der Stützmasse 20.

Nachdem die Gehäusebauteile 19 ausreichend ausgehärtet sind, können sie aus der Halterung 14 herausgestoßen werden (siehe Figur 4 (D)). Zum Herausstoßen der Gehäusebauteile 19 aus der Halterung 14 sind dabei Auswurflöcher 18 im Boden der Halterung 14 vorgesehen. Eine Draufsicht der Halterung ist aus Figur 4 (E) ersichtlich. Durch Herauffahren von Stiften durch diese Auswurflöcher 18 läßt sich das Gehäusebauteil 19 von der Halterung 14 abstoßen.

Zu diesem Zweck ist es zwingend notwendig, daß alle Oberflächen der Halterung 14, die mit dem Gehäusebauteil in Berührung kommen können, insbesondere die Innenwände 15 der Halterung 14, aus nichthaftendem Material bestehen. Ansonsten würden die gerade aufgebrachten Gehäuseteile 19 durch das Herausstoßen aus der Halterung14 möglicherweise wieder abgelöst werden.

Als nichthaftendes Material sollte ein Material verwendet werden, das physikalisch bzw. chemisch nicht mit dem Material des Gehäusebauteils 19, insbesondere bei hohen Temperaturen, reagiert. Des weiteren sollte das nichthaftende Material bei den angewendeten hohen Prozeßtemperaturen konsistent bleiben. Typischerweise wird als nichthaftendes Material Teflon verwendet. Es ist jedoch auch denkbar, jedes andere Material zu verwenden, das obige Anforderungen erfüllt.

Anschließend können die Gehäusebauteile 19 elektrisch bzw. funktional getestet werden. Getestete Gehäusebauteile 19 werden dann typischerweise durch ein Lasermarkiergerät gekennzeichnet.

Je nach Anforderungen werden die Gehäusebauteile 19 anschließend auf eine Leiterplatte 10 bzw. eine Platine kontaktiert. Es erweist sich hierbei als vorteilhaft, wenn die Bereiche zwischen Gehäusebauteil 19 und Platine bzw. Leiterplatte 10 durch ein gängigen Füllstoff 12 aufgefüllt werden. Durch diese Maßnahme wird gewährleistet, daß die elektrischen Kontakte bzw. die Anschlußelemente 5 vor mechanischen Streß geschützt werden. Leitungsbrüche können so vermieden werden. Des weiteren wird durch diese Maßnahme gewährleistet, daß die Anschlußelemente 5 bzw. die Metallisierung der Leiterplatte 10 und des Siliziumchips 2 vor Feuchtigkeit und somit vor Korrosion geschützt werden. Dies erhöht die Zuverlässigkeit und Ausbeute der Gehäusebauteile 19.

Es ist vorteilhaft, wenn mehrere Gehäusebauteile 19 gleichzeitig prozessiert werden können. Aus diesem Grund ist es vorteilhaft, wenn die Halterung 14 für die Gehäusebauteile 19 aus einer m x n -Matrix bestehen, wobei m die Anzahl der Spalten und n die Anzahl der Zeilen der Halterung 14 bezeichnet. In dieser m x n -Halterungsmatrix lassen sich dann m x n Gehäusebauteile 19 gleichzeitig fertigen. Dies senkt vorteilhafterweise die Herstellungskosten der Gehäusebauteile 19.

Besonders vorteilhaft ist die Erfindung bei der Verwendung in einem sogenannten Chip-Scaled-Package-Gehäuse. Dabei kann der Halbleiterkörper 2 beispielsweise eine in sogenannter Flip-Chip-Technologie hergestellter Halbleiterkörper sein. Besonders vorteilhaft ist die Erfindung, wenn die Anschlußelemente 5 kugelförmig ausgebildet sind und in Form einer Matrix an den Halbleiterkörper 2 gebondet sind. Ein derartiges Bauteil wird allgemein als Ball-Grid-Array-Gehäuse (BGA-Gehäuse) bezeichnet. Besonders vorteilhaft ist auch die Verwendung des BGA-Gehäuses in Kombination mit der CSP-Technologie. In diesem Fall wird das Gehäuse als Micro-Ball-Grid-Array-Gehäuse (µ-BGA) bezeichnet.

## Patentansprüche

1. Gehäuse für zumindest einen Halbleiterkörper,
(a) wobei der Halbleiterkörper (2) eine erste und zweite Oberfläche (4, 8), eine den Halbleiterkörper (2) umfassende Randfläche (7) und eine Vielzahl von Kontaktstellen (3) an der ersten Oberfläche (4) aufweist,
(b) mit einer Vielzahl von Anschlußelementen (5), die mindestens teilweise mit den Kontaktstellen (3) des Halbleiterkörpers (2) kontaktiert sind und über die der Halbleiterkörper (2) mit einer Leiterplatte (10) elektrisch kontaktierbar ist,
(c) wobei das Gehäuse (1) zweiteilig ausgeführt ist,
- wobei der erste Teil des Gehäuses (1) einen dünnen Stützrahmen (6) aufweist, der die Randfläche (7) des Halbleiterkörpers (2) vollständig umfaßt und sich am Rand des Halbleiterkörpers (2) von der zweiten Oberfläche (8) des Halbleiterkörpers (2) abhebt, und
- der zweite Teil des Gehäuses (1) einen flach ausgebildeteten Deckel (9) aufweist, der flächendeckend die zweite Oberfläche (8) und zumindest teilweise die obere Kante des Stützrahmens (6) überdeckt,
(d) wobei der Stützrahmen (6) aus einer ersten Masse (20) und der Deckel aus einer zweiten Masse (21) besteht, wobei die erste Masse (20) mindestens teilweise aus einem Polymer besteht, und wobei die zweite Masse (21) mindestens teilweise aus Harz besteht.

2. Gehäuse nach Anspruch 1
**dadurch gekennzeichnet,**
**daß** die nicht mit Kontaktstellen (3) versehenen Bereiche an der ersten Oberfläche (4) des Halbleiterkörpers (2) mit einer Passivierungsschicht (13) überdeckt sind.

3. Gehäuse nach Anspruch 1 oder 2,
**dadurch gekennzeichnet,**
**daß** die Bereiche zwischen den Anschlußelementen (5) und der Leiterplatte (10) mindestens teilweise durch einen Füllstoff (12) aufgefüllt sind.

4. Verfahren zur Herstellung von zumindest einem Gehäuse nach einem der Ansprüche 1 bis 3,
**gekennzeichnet durch**
folgende Verfahrensschritte:
a) es wird eine Halterung (14) bereitgestellt, die zur Aufnahme des mit Anschlußelementen (5) versehenen Halbleiterkörpers (2) vorgesehen ist,
b) der Halbleiterkörper (2) wird in der Weise in der Halterung (14) positioniert, daß Randfläche (7) des Halbleiterkörpers (2) und die Halterung (14) **durch** einen Spalt (16) beabstandet sind,
c) in den Spalt (16) wird die erste Masse (20) für den Stützrahmen (6) eingebracht,
d) auf die zweite Oberfläche (8) des Halbleiterkörpers (2) wird flächendeckend die zweite Masse (21) für den Deckel (9) aufgebracht,
e) der Stützrahmen (6) und der Deckel (9) werden ausgehärtet,
f) die Gehäusebauteile (19) werden aus der Halterung (14) herausgelöst.

5. Verfahren nach Anspruch 4,
**dadurch gekennzeichnet,**
**daß** die Halterung (14) eine Innenwand (15) aufweist, wobei die Innenwand (15) mindestens teilweise aus nichthaftendem Material besteht.

6. Verfahren nach Anspruch 5,
**dadurch gekennzeichnet,**
**daß** das nichthaftende Material der Innenwand (15) Teflon ist.

7. Verfahren nach einem der Ansprüche 5 oder 6,
**dadurch gekennzeichnet,**
**daß** die Halterung (14) eine Matrix-ähnliche Form aufweist.

## Claims

1. Package for at least one semiconductor body,
(a) in which case the semiconductor body (2) has a first and a second surface (4, 8), an edge surface (7) which surrounds the semiconductor body (2), and a large number of contact points (3) on the first surface (4),
(b) having a large number of connecting elements (5), at least some of which make contact with the contact points (3) on the semiconductor body (2) and via which the semiconductor body (2) can make electrical contact with a printed circuit board (10),
(c) in which case the package (1) is designed in two parts
- in which the first part of the package (1) has a thin supporting frame (6) which completely surrounds the edge surface (7) of the semiconductor body (2) and is raised above the second surface (8) of the semiconductor body (2) at the edge of the semiconductor body (2), and
- the second part of the package (1) has a cover (9) which is designed to be flat which covers the entire second surface (8) and at least partially covers the upper rim of the supporting frame (6),
(d) in which case the supporting frame (6) is composed of a first compound (20) and the cover is composed of a second compound (21), in which case the first compound (20), is at least partially composed of a polymer and in which case the second compound (21) is at least partially composed of resin.

2. Package according to Claim 1,
**characterized**
**in that** those regions on the first surface (4) of the semiconductor body (2) which are not provided with contact points (3) are covered by a passivation layer (13).

3. Package according to Claim 1 or 2,
**characterized**
**in that** the regions between the connecting elements (5) and the printed circuit board (10) are at least partially filled by a filler (12).

4. Method for producing at least one package according to one of Claims 1 to 3,
**characterized by**
the following method steps:
a) a holder (14) is provided, which is intended to accommodate the semiconductor body (2) provided with connecting elements (5),
b) the semiconductor body (2) is positioned in the holder (14) in such a way that the edge surface (7) of the semiconductor body (2) and the holder (14) are spaced apart by a gap (16),
c) the first compound (20) for the supporting frame (6) is introduced into the gap (16),
d) the second compound (21) for the cover (9) is applied, covering the entire surface, to the second surface (8) of the semiconductor body (2),
e) the supporting frame (6) and the cover (9) are cured,
f) the package components (19) are released from the holder (14).

5. Method according to Claim 4,
**characterized**
**in that** the holder (14) has an inner wall (15), in which case the inner wall (15) is at least partially composed of non-adhering material.

6. Method according to Claim 5,
**characterized**
**in that** the non-adhering material of the inner wall (15) is Teflon.

7. Method according to one of Claims 5 or 6,
**characterized**
**in that** the holder (14) has a matrix-like shape.

## Revendications

1. Boîtier pour au moins un corps semi-conducteur,
(a) le corps semi-conducteur (2) présentant une première et une deuxième surface (4, 8), une surface périphérique (7) entourant le corps semi-conducteur (2) et une multitude de points de contact (3) au niveau de la première surface (4),
(b) avec une multitude d'éléments de connexion (5) qui sont au moins partiellement en contact avec les points de contact (3) du corps semi-conducteur (2) et par lesquels le corps semi-conducteur (2) peut être mis en contact électrique avec une carte imprimée (10),
(c) le boîtier (1) étant réalisé en deux parties,
- la première partie du boîtier (1) présentant un cadre de support (6) fin qui entoure entièrement la surface périphérique (7) du corps semi-conducteur (2) et se détache au niveau de la périphérie du corps semi-conducteur (2) de la deuxième surface (8) du corps semi-conducteur (2), et
- la deuxième partie du boîtier (1) présentant un couvercle (9) de forme plate qui recouvre en superficie la deuxième surface (8) et au moins partiellement le bord supérieur du cadre de support (6),
(d) le cadre de support (6) étant constitué d'une première masse (20) et le couvercle d'une deuxième masse (21), la première masse (20) étant constituée au moins partiellement d'un polymère, et la deuxième masse (21) étant constituée au moins partiellement d'une résine.

2. Boîtier selon la revendication 1, **caractérisé en ce que** les zones de la première surface (4) du corps semi-conducteur (2) non dotées de points de contact (3) sont recouvertes par une couche de passivation (13).

3. Boîtier selon la revendication 1 ou 2,
**caractérisé en ce que** les zones entre les éléments de connexion (5) et la carte imprimée (10) sont remplies au moins partiellement par une matière de charge (12).

4. Procédé pour fabriquer au moins un boîtier selon l'une quelconque des revendications 1 à 3, **caractérisé par** les étapes de procédé suivantes :
a) on fabrique une monture (14) qui est prévue pour recevoir le corps semi-conducteur (2) doté d'éléments de connexion (5),
b) le corps semi-conducteur (2) est positionné dans la monture (14) de telle sorte que la surface périphérique (7) du corps semi-conducteur (2) et la monture (14) sont espacées par un interstice (16),
(c) dans l'interstice (16) est déposée la première masse (20) pour le cadre de support (6),
(d) sur la deuxième surface (8) du corps semi-conducteur (2) est déposée sur toute la surface la deuxième masse (21) pour le couvercle (9),
(e) le cadre de support (6) et le couvercle (9) sont cuits,
(f) les composants sous boîtier (19) sont expulsés de la monture (14).

5. Procédé selon la revendication 4, **caractérisé en ce que** la monture (14) présente une paroi intérieure (15), la paroi intérieure (15) étant constituée au moins partiellement d'une matière non adhérente.

6. Procédé selon la revendication 5, **caractérisé en ce que** la matière non adhérente de la paroi intérieure (15) est du Téflon.

7. Procédé selon la revendication 5 ou 6, **caractérisé en ce que** la monture (14) présente une forme semblable à une matrice.
